# EUROPÄISCHE PATENTSCHRIFT

(11) **EP 2 055 155 B1**
(45) Veröffentlichungstag und Bekanntmachung des Hinweises auf die Patenterteilung: **12.01.2011**
(21) Anmeldenummer: 07817672.4
(22) Anmeldetag: 16.10.2007
(51) Int. Cl.: H05K 1/18, H05K 5/00, B60R 16/023

(54) **STEUERGERÄT FÜR EIN KRAFTFAHRZEUG**
CONTROL UNIT FOR A MOTOR VEHICLE
APPAREIL DE COMMANDE POUR VEHICULE AUTOMOBILE

(30) Priorität: 20.10.2006 DE 102006049592
(43) Veröffentlichungstag der Anmeldung: 06.05.2009
(73) Patentinhaber: Conti Temic microelectronic GmbH, 90411 Nürnberg (DE)
(72) Erfinder: EGLINGER, Markus, 48188 Canton. MI (US); HENNIGER, Jürgen, 91056 Erlangen-Dechsendorf (DE); GRAMANN, Matthias, 77871 Renchen (DE); WENK, Alexander, 91595 Burgoberbach (DE)
(86) Internationale Anmeldenummer: PCT/DE2007/001837
(87) Internationale Veröffentlichungsnummer: WO 2008/046401

(56) Entgegenhaltungen:
- WO-A-92/12875
- DE-A1- 3 913 066
- DE-A1- 4 340 280
- DE-A1- 19 907 949
- DE-C1- 19 712 842
- US-A- 5 831 836

## Beschreibung

Die Erfindung betrifft ein Steuergerät für ein Kraftfahrzeug nach dem Oberbegriff des Anspruchs 1 sowie ein Verfahren zu dessen Herstellung nach Anspruch 10.

Im Kraftfahrzeugbau ist es seit längerer Zeit üblich, Steuergeräte für Motor oder Getriebe in die zu steuernde Kraftfahrzeugbaugruppe, also Motor oder Getriebe, zu integrieren. Insbesondere die Getriebesteuergeräte bilden als Vorortsteuergerät eine äußerst kompakte Einheit. Im Vergleich zur konventionellen Verwendung externer Steuergeräte hat diese Anordnung enorme Vorteile im Bezug auf Kosten, Gewicht, Funktionalität und Qualität. Insbesondere resultiert daraus eine erhebliche Verringerung an Steckverbindungen und Leitungen.

Die Integration des Steuergerätes in das Getriebe stellt hohe Anforderungen an seine thermische und mechanische Belastbarkeit. Die Funktionalität muss sowohl über einen breiten Temperaturbereich (etwa -40°C bis 150°C) als auch bei starken mechanischen Vibrationen (bis zu etwa 40g) gewährleistet sein. Da das Steuergerät von Getriebeöl umgeben ist, muss es zudem öldicht ausgeführt sein.

Ein derartiges Steuergerät ist aus der DE 199 07 949 A1 bekannt. Ein Gehäusedeckel und eine Bodenplatte, auf der ein flächiger flexibler Folienleiter aufgebracht ist, umschließen einen Hohlraum. In diesem Hohlraum ist auf der Bodenplatte eine elektronische Schaltung so angeordnet, dass sie allseitig von der flexiblen Leiterplatte umgeben ist. Dabei sind Leiterbahnen der flexiblen Leiterpatte über Bonddrähte mit entsprechenden Kontaktpads auf dem Schaltungsträger verbunden. Der Gehäusedeckel ist über eine umlaufende Ringdichtung öldicht auf die Bodenplatte montiert. Die flexible Leiterplatte ist zwischen der Ringdichtung und der Bodenplatte aus dem Hohlraum des Steuergerätegehäuses heraus geführt. Die flexible Leiterplatte stellt die Verbindung.zwischen der elektronischen Schaltung im Hohlraum des Steuergerätegehäuses zu Elektrobauteilen wie Sensoren oder Aktoren außerhalb des Hohlraums her.

Die flexible Leiterpatte ist aus einem Stück. Bei komplexen Anordnungen des Steuergerätes und der umgebenden Bauteile führt dies, rechnet man nur die Aussparung für die elektronische Schaltung in der Mitte der flexiblen Leiterpatte, zu einem großen Verschnitt an Leiterplattenmaterial und ist deshalb unwirtschaftlich.

Darüber hinaus ist mit der Form der flexiblen Leiterpatte die Position der Elektrobauteile beispielsweise außerhalb des Hohlraums festgelegt und erfordert bei der Änderung der Lage nur eines Bauteiles die Änderung der Form der gesamten flexiblen Leiterpatte.

Dokument DE 39 13 66 beschreibt ein Steuergerät gemäss dem Oberbegriff des Anspruchs 1.

Der Erfindung liegt die Aufgabe zu Grunde, ein Steuergerät für ein Kraftfahrzeug zu schaffen, das eine fertigungstechnisch flexible und mechanisch sichere elektrische Verbindung der Steuerelektronik des Steuergerätes mit externen elektronischen Bauteilen in einer kompakten Bauweise ermöglicht.

Diese Aufgabe wird erfindungsgemäß gelöst durch ein Steuergerät mit den Merkmalen des Anspruchs 1.

Der Schaltungsträger mit den elektronischen Bauteilen und den elektrischen Kontaktbereichen ist auf der Gehäusedeckelinnenseite vorzugsweise mittig angeordnet und zum Beispiel mittels Wärmeleitkleber mit dem Gehäusedeckel verklebt. Der Gehäusedeckel weist in dem den Schaltungsträger umlaufend umgebenden Bereich, benachbart zu einem elektronischen Bauteil und/oder einem elektrischen Kontaktbereich zumindest einen Durchbruch auf. An oder in dem Durchbruch ist von der dem Schaltungsträger abgewandten Seite des Gehäusedeckels, also von der Außenseite her, jeweils ein flexibler Folienleiterstreifen angeordnet. Der Folienleiterstreifen weist an mindestens einem Endabschnitt jeweils einen elektrischen Kontaktbereich auf. Der Folienleiterstreifen ist so auf dem Gehäusedeckel angeordnet, dass ein Endabschnitt den Durchbruch vollständig überdeckt und der Kontaktbereich des Endabschnitts vollständig im Durchbruch liegt.

Dadurch, dass die Folienleiter als separate Folienleiterstreifen ausgeführt sind, wird Folienleitermaterial gespart und bei Änderungen der Position eines elektronischen Bauteils außerhalb des Steuergerätes kann die Position des entsprechenden Folienleiters unter Beibehaltung der Position der übrigen Folienleiter schnell angepasst werden.

Vorteilhafterweise ist eine Deckelplatte auf der Außenseite des Gehäusedeckels so angebracht, dass sie den Durchbruch vollständig überdeckt und dass der dazwischen liegende Folienleiterstreifen öldicht mit dem Gehäusedeckel verbunden ist. Der elektrische Kontakt zwischen den Bauteilen und/oder den Kontaktbereichen auf dem Schaltungsträger und dem elektrischen Kontaktbereich am Endabschnitt eines Folienleiterstreifens im entsprechenden Durchbruch wird über entsprechende elektrische Verbindungsleitungen, insbesondere Bonddrähte, hergestellt.

In dem Fall, dass das Steuergerät von einem Fluid, zum Beispiel Motor- oder Getriebeöl, umgeben ist, das in der Umgebung des Steuergerätes eine geringere Temperatur aufweist als die Wärme erzeugenden Bauteilen auf dem Schaltungsträger, wird Wärme in das Fluid abgeführt. Vorteilhafterweise ist dabei der Schaltungsträger direkt auf der Gehäusedeckelinnenseite aufgebracht.

Vorzugsweise wird der Folienleiterstreifen nach dem Positionieren über dem Durchbruch zumindest im unmittelbaren Bereich des Durchbruchs auf den Gehäusedeckel geklebt oder laminiert. Alternativ dazu kann der Folienleiterstreifen auch mit der Deckelplatte fest verbunden werden.

Um die Dichtheit des Bereiches Deckelplatte, Folienleiterstreifen und Durchbruch im Gehäusedeckel zu gewährleisten, kann es unter Umständen nötig sein, eine extra Dichtung zu verwenden. Diese kann als eine den Durchbruch umlaufende Dichtung zwischen dem Gehäusedeckel und dem Folienleiterstreifen oder zwischen dem Folienleiterstreifen und der Deckelplatte angeordnet sein. Dabei ist darauf zu achten, dass die Dichtung gänzlich auf dem Folienleiterstreifen verläuft. Ein Übergang vom Folienleiterstreifen auf den Gehäusedeckel könnte sonst zusätzliche Dichtigkeitsproblerne verursachen.

Um das Steuergerät noch kompakter auszuführen, können die Deckelplatten in dem Gehäusedeckel, insbesondere bündig mit der Gehäusedeckelaußenseite, versenkt sein. Dazu sind auf der Gehäusedeckelaußenseite im Bereich der Durchbrüche stufenförmige, einen Durchbruch umlaufend umgebende Vertiefungen so eingebracht, dass jeder Durchbruch eine entsprechende Deckelplatte aufnehmen kann. Die Verbindung zwischen der Deckelplatte und dem Gehäusedeckel geschieht vorzugsweise durch Verschrauben oder Verstemmen.

Die Bodenplatte muss zur Gewährleistung einer den Anforderungen entsprechenden mechanischen Festigkeit ein gewisse Dicke aufweisen. Vorteilhafterweise sind auf der Bodenplatte zusätzliche Komponenten, wie zum Beispiel Stecker, Sensoren oder Aktoren angeordnet. Um eine möglichst geringe Bauhöhe des Steuergerätes zu erreichen, ist der Gehäusedeckel der Einfachheit halber als flaches Teil und der Hohlraum zwischen dem Gehäusedeckel und der Bodenplatte als eine entsprechende Vertiefung in der Bodenplatte ausgebildet.

Für den Fall, dass das Steuergerät in einem Getriebe eingesetzt wird, wird zusätzlich Bauraum eingespart, indem die Bodenplatte des Steuergerätes ein Teil der Getriebehydraulikeinheit ist, zum Beispiel die Ventilplatte.

Eine weitere Aufgabe der Erfindung ist es, ein Verfahren zur Herstellung eines Steuergerät für ein Kraftfahrzeug nach Anspruch 1 zu schaffen.

Diese Aufgabe wird erfindungsgemäß gelöst durch ein Verfahren mit den Merkmalen des Anspruchs 10.

Zunächst wird ein Schaltungsträger, zum Beispiel mittels eines wärmeleitenden Klebers, direkt auf der Innenseite eines Gehäusedeckels aufgebracht. Auf dem Schaltungsträger sind elektronische Bauelemente und insbesondere auch zusätzliche elektrische Kontaktbereiche aufgebracht, die über Leiterbahnen mit den elektronischen Bauelementen elektrisch verbunden sind, die nicht im Randbereich des Schaltungsträgers angeordnet sind. Dabei weist der Gehäusedeckel in dem den Schaltungsträger umlaufend umgebenden Bereich, benachbart zu einem elektronischen Bauteil und/oder einem elektrischen Kontaktbereich zumindest einen Durchbruch auf.

Anschließend wird vorzugsweise an dem Durchbruch von der dem Schaltungsträger abgewandten Seite des Gehäusedeckels, also von der Außenseite, her jeweils ein flexibler Folienleiterstreifen so auf dem Gehäusedeckel positioniert, dass ein Endabschnitt des Folieneiterstreifens den Durchbruch vollständig überdeckt. Der Endabschnitt weist einen elektrischen Kontaktbereich auf. Bei der Positionierung des Folienleiterstreifens auf dem Gehäusedeckel ist darauf zu achten, dass dieser elektrische Kontaktbereich vollständig im Durchbruch liegt. Das Fixieren der Folienleiterstreifen auf dem Gehäusedeckel geschieht vorzugsweise durch Kaltlaminieren.

Im nächsten Schritt wird eine Deckelplatte derart von außen an dem Durchbruch angebracht, dass der dazwischen liegende Folienleiterstreifen öldicht mit dem Gehäusedeckel verbunden wird. Die Verbindung kann durch Verschrauben oder Verstemmen hergestellt werden. Insbesondere kann eine zusätzliche den Durchbruch umlaufende Dichtung verwendet werden. Diese Dichtung wird wahlweise zwischen dem Gehäusedeckel und dem Folienleiterstreifen oder zwischen dem Folienleiterstreifen und der Deckelplatte angeordnet.

Es wäre auch denkbar, dass der Folienleiterstreifen auf der Deckelplatte fixiert wird. Dann müsste die Dichtung zwangsläufig zwischen dem Gehäusedeckel und dem Folienleiterstreifen angebracht werden.

Danach werden die elektronischen Bauteile und/oder die elektrischen Kontaktbereiche auf dem Schaltungsträger mit den entsprechenden elektrischen Kontaktbereichen auf den Endabschnitten der Folienleiterstreifen in den jeweiligen Durchbrüchen im Gehäusedeckel elektrisch verbunden. Bevorzugt wird hierbei das Anbringen von Bonddrähten. Es ist von Vorteil , dass schon in diesem Stadium die elektrische Funktionalität des Steuergerätes unabhängig von den weiteren Verfahrensschritten und noch hinzukommenden Komponenten geprüft werden kann.

Abschließend wird der Gehäusedeckel auf eine Bodenplatte montiert. Die Öldichtheit wird insbesondere durch eine am Gehäusedeckel oder an der Bodenplatte umlaufende Dichtung gewährleistet. Die Montage des Gehäusedeckels auf die Bodenplatte kann durch Verschrauben, Vernieten , Verkleben oder durch jede andere bekannte Verbindungstechnik geschehen.

Es ist auch denkbar, dass die Bodenplatte ein Teil einer weiteren Fahrzeugkomponente, zum Beispiel einer Getriebehydraulik ist. Eventuell sich in der Bodenplatte befindliche Bauteile, seien es Aktoren zum Betätigen von Ventilen oder Sensoren wie Drucksensoren, sind dann unter Umständen auch mit den elektronischen Bauteilen und/oder die elektrischen Kontaktbereichen auf dem Schaltungsträger vorzugsweise mittels Federkontakten elektrisch verbunden.

Weitere Merkmale, Vorteile und Einzelheiten sind der nachfolgenden Beschreibung entnehmbar, in der bevorzugte Ausführungsbeispiele näher erläutert werden. Es zeigen:
Fig. 1 einen Schnitt durch ein Steuergerät mit der Deckelplatte auf dem Gehäusedeckel,
Fig. 2 einen Ausschnitt aus der Figur 1, wobei die Deckelplatte bündig im Gehäusedeckel versenkt ist,
Fig. 3 eine Draufsicht auf die Gehäusedeckelinnenseite, und
Fig. 4 eine Draufsicht auf die Gehäusedeckelaußenseite.

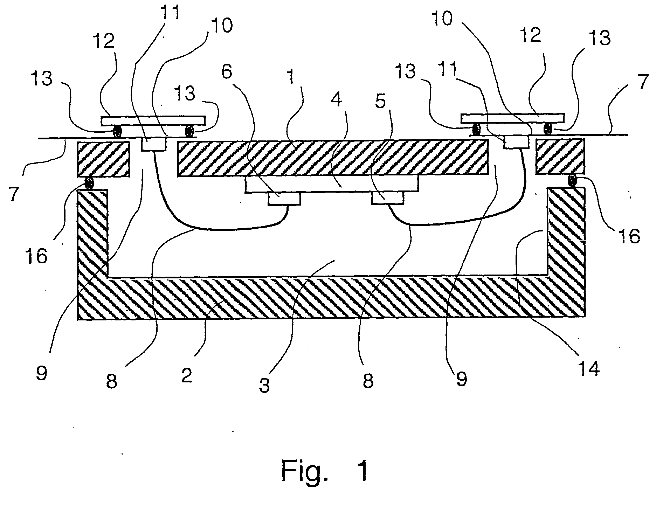

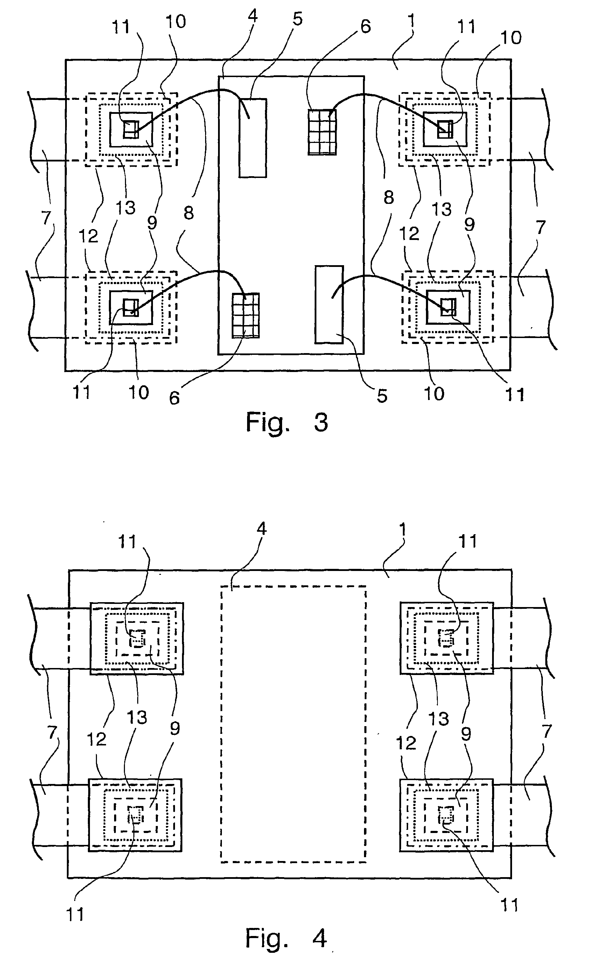

Gemäß Fig. 1 umfasst ein Steuergerät für ein Kraftfahrzeug einen Gehäusedeckel 1 und eine Bodenplatte 2. Der Gehäusedeckel 1 und die Bodenplatte 2 bilden einen Hohlraum 3, in dem sich ein Schaltungsträger 4 befindet. Der Schaltungsträger 4 ist auf der Innenseite des Gehäusedeckels 1 insbesondere mit einem elektrisch isolierenden Wärmeleitkleber aufgeklebt. Ist der Gehäusedeckel 1 zum Beispiel aus einem metallischen Werkstoff, so wird die auf dem Schaltungsträger 4 entstehende Wärme besonders gut an die an den Gehäusedeckel 1 angrenzende Umgebung abgeleitet. Auf dem Schaltungsträger 4 sind mindestens ein elektronisches Bauteil 5 und mindestens ein elektronischer Kontaktbereich 6 angeordnet. Ein Kontaktbereich 6 ist insbesondere über Leiterbahnen auf dem Schaltungsträger 4 mit elektronischen Bauteilen, die sich nicht im Randbereich des Schaltungsträgers 4 befinden, elektrisch verbunden. Der Gehäusedeckel 1 weist in dem den Schaltungsträger 4 umlaufend umgebenden Bereich, benachbart zu einem elektronischen Bauteil 5 und/oder einem elektrischem Kontaktbereich 6, einen Durchbruch 9 auf. Zur Veranschaulichung sei in diesem Zusammenhang auch auf die Fig. 3 verwiesen. Am Durchbruch 9 ist auf der Außenseite des Gehäusedeckels 1, also die dem Schaltungsträger abgewandten Seite des Gehäusedeckels 1 , ein flexibler Folienleiter 7, vorzugsweise als Folienleiterstreifen ausgebildet, angebracht. Am Endabschnitt 10 des Folienleiterstreifens 7 ist ein elektrischer Kontaktbereich 11 angeordnet. Der Folienleiterstreifen 7 ist so über dem Durchbruch 9 platziert, dass er mit seinem Endabschnitt 10 den Durchbruch 9 vollständig überdeckt und dass sich der elektrische Kontaktbereich 11 vollständig im Durchbruch 9 befindet, also nicht mit dem Gehäusedeckel in Kontakt kommt. Andernfalls wäre die Gefahr eines Kurzschlusses gegeben. Der elektrische Kontaktbereich 11 auf dem Folienleiter 7 im Durchbruch 9 ist wiederum über die Leiterbahnen im Folienleiter 7 in nicht gezeigter Weise mit elektronischen und/oder elektrischen Bauteilen, wie Sensoren oder Steckern, außerhalb des Steuergerätes elektrisch verbunden. Die elektrischen Verbindungsleitungen 8, in der Regel sind dies Bonddrähte, wiederum stellen den elektrischen Kontakt zwischen den elektronischen Bauteilen 5 und /oder den elektrischen Kontaktbereichen 6 auf dem Schaltungsträger 4 mit den entsprechenden elektrischen Kontaktbereichen 11 im Durchbruch 9 her. Die Deckelplatte 12 überdeckt den Durchbruch 9 vollständig und bewirkt, dass der Folieneiterstreifen 7 öldicht mit dem Gehäusedeckel 1 verbunden ist. Die Ankopplung der Deckelplatte 12 an den Gehäusedeckel 1 kann durch eine kraft- oder formschlüssige Verbindung wie Verschrauben oder Verstemmen hergestellt werden.

Wie in Fig. 1 gezeigt liegt zwischen dem Folienleiterstreifen 7 und der Deckelplatte 12 eine den Durchbruch 9 umlaufende Ringdichtung 13, um eine zusätzliche Sicherheit bezüglich Öldichtheit zu gewährleisten. Die Dichtung 13 kann der Einfachheit halber an die Deckelplatte 12 angespritzt sein, könnte aber auch in einer entsprechenden Nut an der dem Durchbruch 9 zugewandten Seite der Deckelplatte 12 fixiert sein.

In der in Fig. 1 gezeigten Ausgestaltungsform des Steuergerätes ist der Folienleiterstreifen 7 beispielsweise durch Laminieren, insbesondere Kaltlaminieren, auf dem Gehäusedeckel 1 fixiert. Alternativ dazu wäre es auch vorstellbar, dass der Folieneiterstreifen 7 mit der Deckelplatte 12, beispielsweise stoffschlüssig wie mittels Kleben oder Laminieren, verbunden ist. Dann müsste die Dichtung 13 zwischen dem Gehäusedeckel 1 und dem Folienleiterstreifen 7 angebracht sein.

Der Gehäusedeckel 1 ist über eine Dichtung 16 öldicht an die Bodenplatte 2 gekoppelt. Zur Bildung des Hohlraums 3 zwischen dem Gehäusedeckel 1 und der Bodenplatte 2 weist die Bodenplatte 2 eine quaderförmige Vertiefung 14 auf. Denkbar wäre auch, dass die Bodenplatte 2 als flache Platte und der Gehäusedeckel 1 zur Bildung des Hohlraums 3 haubenförmig ausgebildet ist. Um zu einer sehr kompakten Getriebeeinheit zu gelangen, kann die Bodenplatte 2 des Steuergerätes gleichzeitig ein Teil der Getriebehydraulikeinheit sein.

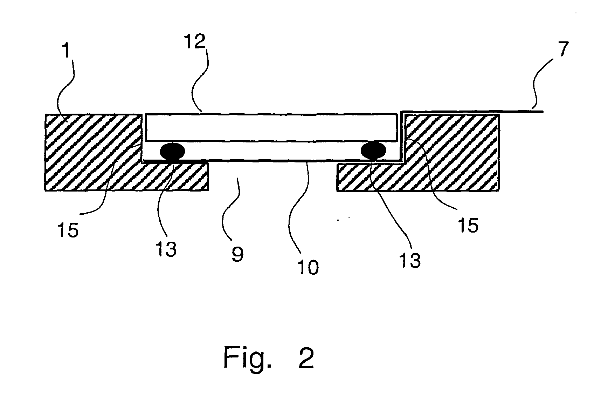

Fig. 2 zeigt eine zu Fig. 1 alternative Anordnung der Deckelplatte 12 am Gehäusedeckel 1. Dazu weist der Gehäusedeckel 1 auf seiner Außenseite im Bereich des Durchbruchs 9 eine den Durchbruch 9 umlaufend umgebende, in seiner Form der Form der Deckelplatte entsprechende Vertiefung 15 auf. Die Deckelplatte 12 ist insbesondere so in der Vertiefung 15 versenkt, dass sie an ihrer Außenseite mit der Außenseite des Gehäusedeckels 1 bündig abschließt. Der Folienleiterstreifen 7 ist wie in Fig. 1 direkt auf dem Gehäusedeckel 1 angeordnet und überdeckt den Durchbruch 9 vollständig. Die Dichtung 13 liegt in der Vertiefung 15 zwischen dem Folienleiterstreifen 7 und der Deckelplatte 12; könnte aber auch zwischen der Vertiefung 15 und dem Folienleiterstreifen 7 angeordnet sein.

Fig. 3 zeigt eine Draufsicht auf die Innenseite des Gehäusedeckels 1 und dient vor allem der Veranschaulichung der Anordnung im Bereich eines Durchbruchs 9. Der elektrische Kontaktbereich 11 auf dem Endabschnitt 10 des Folieneiterstreifens 7 ist so im Durchbruch 9 angeordnet, dass er mit dem Gehäusedeckel 1 nicht in Berührung kommt, also keinen Kurzschluss über den meist metallischen Gehäusedeckel 1 verursachen kann. Um den Durchbruch 9 verläuft die Dichtung 13, entweder zwischen dem Gehäusedeckel 1 und dem Folienleiterstreifen 7 oder zwischen dem Folienleiterstreifen 7 und der Deckelplatte 12. Die Dichtung 13 verläuft gänzlich auf dem Folieneiterstreifen 7, da ein Übergang Dichtung 13 auf Gehäuseplatte 1 eine potentielle Undichtigkeit darstellen würde. Der Endabschnitt 10 des Folienleiterstreifens 7 überdeckt also sowohl den Durchbruch 9 als auch die Dichtung 13 gänzlich. Die Deckelplatte 12 wiederum überdeckt in diesem Fall den Endabschnitt 10 gänzlich. Diese Anordnung ist insbesondere sinnvoll, wenn die Dichtung 13 den Übergang von der Deckelplatte 12 zum Folienleiterstreifen 7 abdichtet. Der Übergang vom Folienleiterstreifen 7 zum Gehäusedeckel 1 wird durch die Art der Aufbringung des Folienleiterstreifens 7 auf den Gehäusedeckel 1, sprich zum Beispiel durch Laminieren oder Kleben, andererseits durch die form- oder kraftschlüssige Anbindung der Deckelplatte 12 an den Gehäusedeckel 1 abgedichtet.

Für den Fall, dass die Dichtung 13 den Übergang vom Gehäusedeckel 1 zum Folienleiterstreifen 7 abdichtet, kann es durchaus Sinn machen, dass die Deckelplatte 12 gänzlich innerhalb des Endabschnitts 10 des Folienleiterstreifens 7 verläuft, um einen Übergang vom Folienleiterstreifen 7 auf den Gehäusedeckel 1 und damit eine potentielle Undichtigkeit zu vermeiden. Zu diesem Zweck kann der Endabschnitt 10, je nach Abmessungen der Deckelplatte, breiter sein als der Rest des Folienleiterstreifens 7.

Fig. 4 zeigt eine Draufsicht auf die Außenseite des Gehäusedeckels 1.

### Bezugszeichenliste

- 1.: Gehäusedeckel
- 2.: Bodenplatte
- 3.: Hohlraum
- 4.: Schaltungsträger
- 5.: Elektronisches Bauteil auf dem Schaltungsträger
- 6.: Elektrischer Kontaktbereich auf dem Schaltungsträger
- 7.: Folienleiter
- 8.: Elektrische Verbindungsleitung
- 9.: Durchbruch im Gehäusedeckel
- 10.: Endabschnitt des Folieneiters zum Schaltungsträger hin
- 11.: Elektrischer Kontaktbereich auf dem Folienleiter
- 12.: Deckelplatte
- 13.: Dichtung, den Durchbruch umlaufend
- 14.: Vertiefung in der Bodenplatte
- 15.: Vertiefung im Gehäusedeckel
- 16.: Dichtung zwischen Gehäusedeckel und Bodenplatte

## Patentansprüche

1. Steuergerät für ein Kraftfahrzeug, das umfasst:
a) eine Bodenplatte (2),
b) einen Gehäusedeckel (1), der öldicht mit der Bodenplatte (2) verbunden ist und mit der Bodenplatte (2) einen Hohlraum (3) bildet,
c) einen Schaltungsträger (4), der mindestens ein elektronisches Bauteil (5) und/oder mindestens einen elektrischen Kontaktbereich (6) umfasst und der innerhalb des Hohlraums (3) auf der Innenseite des Gehäusedeckels (1) angeordnet ist,
d) mindestens einen Folienleiter (7) zum elektrischen Verbinden von mindestens einem elektronischen Bauteil (5) und/oder mindestens einem elektrischen Kontaktbereich (6) auf dem Schaltungsträger (4) mit elektronischen Bauteilen außerhalb des Hohlraums (3), und
e) elektrische Verbindungsleitungen (8) zwischen den Bauteilen (5) und/oder den Kontaktbereichen (6) auf dem Schaltungsträger (4) und dem Folienleiter (7),
**dadurch gekennzeichnet, dass**
f) der Gehäusedeckel (1) in dem den Schaltungsträger (4) umlaufend umgebenden Bereich benachbart zu einem elektronischen Bauteil (5) und/oder einem elektrischen Kontaktbereich (6) des Schaltungsträgers (4) zumindest einen Durchbruch (9) aufweist,
g) der Folienleiter als mindestens ein Folienleiterstreifen (7) ausgeführt ist, der mindestens an einem Endabschnitt (10) jeweils einen elektrischen Kontaktbereich (11) aufweist,
*h)* an oder in dem Durchbruch (9) von der dem Schaltungsträger (4) abgewandten Seite des Gehäusedeckels (1) her jeweils ein Folienleiterstreifen (7) so angeordnet ist, dass der Endabschnitt (10) des Folienleiterstreifens (7) den Durchbruch (9) vollständig überdeckt,
i) über oder in dem Durchbruch (9) eine Deckelplatte (12) den Durchbruch (9) vollständig abdeckend so angebracht ist, dass der dazwischen liegende Folienleiterstreifen (7) öldicht mit dem Gehäusedeckel (2) verbunden ist, und
j) die elektrischen Verbindungsleitungen (8) zwischen den Bauteilen (5) und/oder den Kontaktbereichen (6) auf dem Schaltungsträger (4) und dem elektrischen Kontaktbereich (11) am Endabschnitt (10) des Folienleiterstreifens (7) im entsprechenden Durchbruch (9) angeordnet sind.

2. Steuergerät nach Anspruch 1, **dadurch gekennzeichnet, dass** der Gehäusedeckel (1) mit einem umgebenden Fluid direkt in Verbindung steht und als Wärmesenke für die durch die elektronischen Bauteile (5) auf dem Schaltungsträger (4) erzeugte Wärme ausgebildet ist.

3. Steuergerät nach Anspruch 1 oder 2, **dadurch gekennzeichnet, dass** der Folienleiterstreifen (7) mit dem Gehäusedeckel (1), zumindest im Bereich des Durchbruchs (9), oder mit der Deckelplatte (12) mittels einer stoffschlüssigen Verbindung wie Kleben oder Laminieren verbunden ist.

4. Steuergerät nach einem der vorhergehenden Ansprüche, **dadurch gekennzeichnet, dass** zwischen dem Gehäusedeckel (1) und dem Folienleiterstreifen (7) oder zwischen dem Folienleiterstreifen (7) und der Deckelplatte (12) eine um den Durchbruch (9) umlaufende Dichtung (13) angeordnet ist.

5. Steuergerät nach Anspruch 4, **dadurch gekennzeichnet, dass** die um den Durchbruch (9) umlaufende Dichtung (13) innerhalb des Folienleiterstreifens (7), den elektrischen Kontaktbereich (11) auf dem Folienleiterstreifen (7) umgebend, angeordnet ist.

6. Steuergerät nach einem der vorhergehenden Ansprüche, **dadurch gekennzeichnet, dass** der Gehäusedeckel (1) im Bereich des Durchbruchs (9) eine stufenförmige, den Durchbruch (9) umlaufend umgebende Vertiefung (15) zur Aufnahme der Deckelplatte (12) aufweist.

7. Steuergerät nach einem der vorhergehenden Ansprüche, **dadurch gekennzeichnet, dass** die Bodenplatte (2) eine Vertiefung (14) zur Bildung des Hohlraums (3) mit dem Gehäusedeckel (1) aufweist.

8. Steuergerät nach einem der vorhergehenden Ansprüche, **dadurch gekennzeichnet, dass** die Deckelplatte (12) mit dem Gehäusedeckel (1) mittels einer kraft- oder formschlüssigen Verbindung wie Verschrauben oder Verstemmen verbunden ist.

9. Steuergerät nach einem der vorhergehenden Ansprüche, **dadurch gekennzeichnet, dass** die Bodenplatte (2) ein Teil einer Getriebehydraulikeinheit ist.

10. Verfahren zur Herstellung eines Steuergerätes für ein Kraftfahrzeug nach Anspruch 1, **gekennzeichnet durch** die Schritte:
a) Bereitstellen eines Gehäusedeckels (1),
b) Aufbringen eines Schaltungsträgers (4) auf der Innenseite des Gehäusedeckel (1), wobei der Schaltungsträger (4) mindestens ein elektronisches Bauteil (5) und/oder mindestens einen elektrischen Kontaktbereich (6) umfasst und wobei der Gehäusedeckel (1) in dem den Schaltungsträger (4) umlaufend umgebenden Bereich, benachbart zu einem elektronischen Bauteil (5) und/oder einem elektrischen Kontaktbereich (6), mindestens einen Durchbruch (9) aufweist,
c) Positionieren und Fixieren mindestens eines streifenförmigen Folienleiters (7) auf der dem Schaltungsträger (4) abgewandten Seite des Gehäusedeckels (1) derart, dass ein Endabschnitt (10) des Folienleiterstreifens (7) den Durchbruch (9) vollständig überdeckt und ein elektrischer Kontaktbereich (11) auf dem Endabschnitt (10) des Folienleiterstreifens (7) im jeweiligen Durchbruch (9) vollständig angeordnet wird,
d) Anbringen einer Deckelplatte (12) an den Durchbruch (9) derart, dass der dazwischen liegende Folienleiterstreifen (7) öldicht mit dem Gehäusedeckel (1) verbunden wird,
e)Anbringen von elektrischen Verbindungsleitungen (8) zwischen den elektronischen Bauteilen (5) und/oder den Kontaktbereichen (6) auf dem Schaltungsträger (4) und dem elektrischen Kontaktbereich (11) am Endabschnitt (10) des Folienleiterstreifens (7) im entsprechenden Durchbruch (9), und
f) öldichte Montage des Gehäusedeckels (1) an die Bodenplatte (2), wobei ein Hohlraum (3) zur Aufnahme des Schaltungsträgers (4) gebildet wird.

11. Verfahren nach Anspruch 10, **dadurch gekennzeichnet, dass**
der Schaltungsträger (4) und/oder der mindestens eine Folienleiterstreifen (7) mittels Kleben oder Laminieren, insbesondere Kaltlaminieren, auf den Gehäusedeckel (1) oder die Deckelplatte (12) aufgebracht wird.

## Claims

1. A control device for a motor vehicle, comprising:
a) a bottom plate (2),
b) a housing lid (1) which is connected to the bottom plate (2) in an oil-tight manner and forms a hollow space (3) with the bottom plate (2),
c) a circuit carrier (4) which comprises at least one electronic component (5) and/or at least one electrical contact area (6) and which is arranged within the hollow space (3) on the inside of the housing lid (1),
d) at least one foil conductor (7) for electrically connecting at least one electronic component (5) and/or at least one electrical contact area (6) on the circuit carrier (4) to electronic components outside the hollow space (3), and
e) electrical connection lines (8) between the components (5) and/or the contact areas (6) on the circuit carrier (4) and the foil conductor (7),
**characterized in that**
f) the housing lid (1) has at least one opening (9) in the area continuously surrounding the circuit carrier (4) adjacent to an electronic component (5) and/or an electrical contact area (6) of the circuit carrier (4),
g) the foil conductor is designed as at least one foil conductor strip (7) which comprises an electrical contact area (11) in each case on at least one end section (10),
h) on or in the opening (9), from the side of the housing lid (1) facing away from the circuit carrier (4), a foil conductor strip (7) is arranged in such a manner that the end section (10) of the foil conductor strip (7) covers the opening (9) completely,
i) over or in the opening (9), a cover plate (12) is affixed so as to cover the opening (9) completely, in such a manner that the foil conductor strip (7) sandwiched between is connected to the housing lid (2) in an oil-tight manner, and
j) the electrical connection lines (8) between the components (5) and/or the contact areas (6) on the circuit carrier (4) and the electrical contact area (11) on the end section (10) of the foil conductor strip (7) are arranged in the respective opening (9).

2. A control device according to claim 1, **characterized in that** the housing lid (1) is in direct contact with a surrounding fluid and is designed as a heat sink for the heat produced by the electronic components (5) on the circuit carrier (4).

3. A control device according to claim 1 or 2, **characterized in that** the foil conductor strip (7) is connected to the housing lid (1), at least in the area of the opening (9), or to the cover plate (12) by means of an adhesive connection such as gluing or laminating.

4. A control device according to any one of the preceding claims, **characterized in that** a seal (13) continuously surrounding the opening (9) is arranged between the housing lid (1) and the foil conductor strip (7) or between the foil conductor strip (7) and the cover plate (12).

5. A control device according to claim 4, **characterized in that** the seal (13) continuously surrounding the opening (9) is arranged within the foil conductor strip (7) so as to surround the electrical contact area (11) on the foil conductor strip (7).

6. A control device according to any one of the preceding claims, **characterized in that** the housing lid (1) comprises a step-shaped depression (15) for receiving the cover plate (12) in the area of the opening (9), which depression continuously surrounds the opening (9).

7. A control device according to any one of the preceding claims, **characterized in that** the bottom plate (2) comprises a depression (14) for forming the hollow space (3) with the housing lid (1).

8. A control device according to any one of the preceding claims, **characterized in that** the cover plate (12) is connected to the housing lid (1) by means of a force- or form-fit connection such as screwing or clamping.

9. A control device according to any one of the preceding claims, **characterized in that** the bottom plate (2) is a part of a gearbox hydraulic unit.

10. A method for producing a control device for a motor vehicle according to claim 1, **characterized by** the steps of:
a) providing a housing lid (1),
b) attaching a circuit carrier (4) to the inside of the housing lid (1), wherein the circuit carrier (4) comprises at least one electronic component (5) and/or at least one electrical contact area (6) and wherein the housing lid (1) has at least one opening (9) in the area continuously surrounding the circuit carrier (4) adjacent to an electronic component (5) and/or an electrical contact area (6),
c) positioning and fixing at least one strip-shaped foil conductor (7) on the side of the housing lid (1) which faces away from the circuit carrier (4) in such a manner that an end section (10) of the foil conductor strip (7) covers the opening (9) completely and an electrical contact area (11) is completely arranged on the end section (10) of the foil conductor strip (7) in the respective opening (9),
d) affixing a cover plate (12) to the opening (9) in such a manner that the foil conductor strip (7) sandwiched between is connected to the housing lid (1) in an oil-tight manner,
e) affixing electrical connection lines (8) between the electronic components (5) and/or the contact areas (6) on the circuit carrier (4) and the electrical contact area (11) on the end section (10) of the foil conductor strip (7) in the respective opening (9), and
f) oil-tight mounting of the housing lid (1) to the bottom plate (2), wherein a hollow space (3) for receiving the circuit carrier (4) is formed.

11. A method according to claim 10, **characterized in that** the circuit carrier (4) and/or the at least one foil conductor strip (7) is attached to the housing lid (1) or the cover plate (12) by gluing or laminating, in particular by cold lamination.

## Revendications

1. Appareil de commande pour un véhicule automobile, qui comprend :
a) une plaque de fond (2),
b) un couvercle de carter (1) qui est raccordé à la plaque de fond (2) de façon étanche à l'huile et qui forme une cavité (3) avec la plaque de fond (2),
c) un support de circuit (4) qui comprend au moins un composant (5) électronique et/ou au moins une zone de contact (6) électrique et qui est disposé à l'intérieur de la cavité (3) sur le côté intérieur du couvercle de carter (1),
d) au moins un conducteur en lamelles (7) pour la connexion électrique d'au moins un composant (5) électronique et/ou d'au moins une zone de contact (6) électrique sur le support de circuit (4) avec des composants électroniques à l'extérieur de la cavité (3), et
e) des lignes de connexion électriques (8) entre les composants (5) et/ou les zones de contact (6) sur le support de circuit (4) ou le conducteur en lamelles (7),
**caractérisé en ce que**
f) dans la zone entourant de façon périphérique le support de circuit (4) à proximité d'un composant (5) électronique et/ou d'une zone de contact (6) électrique du support de circuit (4), le couvercle de carter (1) présente au moins une traversée (9),
g) le conducteur en lamelles est exécuté au moins comme une bande de conducteur en lamelles (7) qui présente une zone de contact (11) électrique au moins à un tronçon d'extrémité (10) respectivement,
h) sur ou dans la traversée (9), à partir du côté du couvercle de carter (1) qui est éloigné du support de circuit (4), il est respectivement disposé une bande de conducteur en lamelles (7) de sorte que le tronçon d'extrémité (10) de la bande de conducteur en lamelles (7) recouvre complètement la traversée (9),
i) au-dessus ou dans la traversée (9), il est placé une plaque de couvercle (12) recouvrant complètement la traversée (9) de sorte que la bande de conducteur en lamelles (7) située au milieu est raccordée au couvercle de carter (2) de façon étanche à l'huile , et
j) les lignes de connexion électriques (8) entre les composants (5) et/ou les zones de contact (6) sur le support de circuit (4) et la zone de contact (11) électrique sur le tronçon d'extrémité (10) de la bande de conducteur en lamelles (7) sont disposées dans la traversée (9) correspondante.

2. Appareil de commande selon la revendication 1, **caractérisé en ce que** le couvercle de carter (1) est en contact direct avec un fluide environnant et est constitué en tant que puits de chaleur pour la chaleur produite par les composants (5) électroniques sur le support de circuit (4).

3. Appareil de commande selon la revendication 1 ou 2, **caractérisé en ce que** la bande de conducteur en lamelles (7) est raccordée au couvercle de carter (1), au moins dans la zone de la traversée (9), ou à la plaque de couvercle (12) au moyen d'une liaison par adhérence telle que l'encollage ou le plastifiage.

4. Appareil de commande selon une des revendications précédentes, **caractérisé en ce que**, entre le couvercle de carter (1) et la bande de conducteur en lamelles (7) ou entre la bande de conducteur en lamelles (7) et la plaque de couvercle (12), il est disposé un joint d'étanchéité (13) périphérique autour de la traversée (9).

5. Appareil de commande selon la revendication 4, **caractérisé en ce que** le joint d'étanchéité (13) périphérique autour de la traversée (9) est disposé à l'intérieur de la bande de conducteur en lamelles (7), entourant la zone de contact (11) électrique sur la bande de conducteur en lamelles (7).

6. Appareil de commande selon une des revendications précédentes, **caractérisé en ce que** le couvercle de carter (1) présente, dans la zone de la traversée (9), un creux (15) en forme de gradin destiné à loger la plaque de couvercle (12) et entourant de façon périphérique la traversée (9).

7. Appareil de commande selon une des revendications précédentes, **caractérisé en ce que** la plaque de fond (2) présente un creux (14) pour la formation de la cavité (3) avec le couvercle de carter (1).

8. Appareil de commande selon une des revendications précédentes, **caractérisé en ce que** la plaque de couvercle (12) est raccordée au couvercle de carter (1) au moyen d'une liaison de force ou d'une liaison de forme comme le vissage ou le matage.

9. Appareil de commande selon une des revendications précédentes, **caractérisé en ce que** la plaque de fond (2) fait partie d'une unité hydraulique d'engrenage.

10. Procédé de fabrication d'un appareil de commande pour un véhicule automobile selon la revendication 1, **caractérisé par** les étapes:
a) fourniture d'un couvercle de carter (1),
b) mise en place d'un support de circuit (4) sur le côté intérieur du couvercle de carter (1), le support de circuit (4) comprenant au moins un composant (5) électronique et/ou au moins une zone de contact (6) électrique, et le couvercle de carter (1) présentant au moins une traversée (9) dans la zone entourant de façon périphérique le support de circuit (4) à proximité d'un composant (5) électronique et/ou d'une zone de contact (6) électrique,
c) positionnement et fixation d'au moins un conducteur en lamelles (7) en forme de bande sur le côté du couvercle de carter (1) éloigné du support de circuit (4) de sorte qu'un tronçon d'extrémité (10) de la bande de conducteur en lamelles (7) recouvre complètement la traversée (9) et qu'une zone de contact (11) électrique est entièrement disposée sur le tronçon d'extrémité (10) de la bande de conducteur en lamelles (7) dans la traversée (9) respective,
d) mise en place d'une plaque de couvercle (12) sur la traversée (9) de sorte que la bande de conducteur en lamelles (7) située au milieu est raccordée au couvercle de carter (1) de façon étanche à l'huile,
e) mise en place de lignes de connexion électriques (8) entre les composants (5) électroniques et/ou les zones de contact (6) sur le support de circuit (4) et la zone de contact (11) électrique sur le tronçon d'extrémité (10) de la bande de conducteur en lamelles (7) dans la traversée (9) correspondante, et
f) montage étanche à l'huile du couvercle de carter (1) sur la plaque de fond (2), une cavité (3) étant formée pour recevoir le support de circuit (4).

11. Procédé selon la revendication 10, **caractérisé en ce que** le support de circuit (4) et/ou la bande de conducteur en lamelles (7) au moins au nombre de un est mis/mise en place sur le couvercle de carter (1) ou la plaque de couvercle (12) au moyen de collage ou de plastifiage, en particulier de plastifiage à froid.
